# EUROPÄISCHE PATENTANMELDUNG

(11) **EP 1 308 967 A2**
(43) Veröffentlichungstag der Anmeldung: **07.05.2003**
(21) Anmeldenummer: 02022743.5
(22) Anmeldetag: 11.10.2002
(51) Int. Cl.: H01B 1/02

(54) **Manteldraht, insbesondere Anschlussdraht für elektrische Temperatursensoren**

(30) Priorität: 31.10.2001 DE 10153217
(71) Anmelder: Heraeus Sensor-Nite GmbH, 63450 Hanau (DE)
(72) Erfinder: Wienand, Karlheinz, Dr., 63741 Aschaffenburg (DE); Ullrich, Karlheinz, Dr., 64823 Grossumstadt (DE)
(74) Vertreter: Kühn, Hans-Christian

(57) **Zusammenfassung**

Als Anschlussdraht für elektrische Temperaturensensoren ist ein Manteldraht vorgesehen, der einen Kern aus einer sich an der Kernoberfläche selbst passivierenden Nickel-Basis-Legierung aufweist, wobei der Kern einen Mantel aus Platin aufweist. Eine geeignete, sich an der Kernoberfläche selbst passivierende Nickel-Basis-Legierung weist Chrom im Bereich von 16 bis 22 Gew-%, vorzugsweise von 20 Gew-%, auf.

## Beschreibung

Die Erfindung betrifft Manteldrähte, insbesondere Anschlussdrähte für elektrische Temperaturensensoren, mit einem Mantel, der Platin aufweist und der einen Kern aus einer Legierung umhüllt. Des weiteren betrifft die Erfindung die Verwendung eines solchen Manteldrahtes.

Aus der DE 38 32 342 ist ein Manteldraht mit einem Mantel aus Platin bekannt, der einen Kern aus einer Palladium-Legierung mit 1-5 Gew.-% Wolfram einhüllt. Das Mantelvolumen allein beträgt pro Längeneinheit 10-50 % bezogen auf das Gesamtvolumen des Manteldrahtes. Zur Herstellung wird ein stabförmiger Kernwerkstoff aus einer Palladium-Legierung, die 1-5 Gew.-% Wolfram aufweist, in ein Rohr aus Platin eingebracht und diese Stabrohranordnung wird auf einen Enddrahtdurchmesser gezogen. Solche Manteldrähte werden vorzugsweise als Anschlussleitungen bzw. Zuleitungsdrähte für Widerstandsthermometer mit einem Messwiderstand aus Platin verwendet.

Als problematisch erweist sich die verhältnismäßig niedrige Obergrenze der Temperatur (in der Praxis bei ca. 600°C), woraus sich nur ein beschränkter Anwendungsbereich ergibt; bei erhöhten Temperaturen muss damit gerechnet werden, dass der Werkstoff des Kerns durch den Platinmantel diffundiert und auf der äußersten Oberfläche oxidiert. Dabei verringert sich der elektrische Kontakt zu einem Chip-Anschluss (Anschluss-Pad), wobei sich auch die erforderliche mechanische Festigkeit verringert.

Darüber hinaus sind die verhältnismäßig hohen Werkstoffkosten in der Praxis als Problem anzusehen.

Ähnlich verhält es sich auch für die in der DE 41 25 980 A1 offenbarten Manteldrähte mit einem Kern aus Nickel und einem Mantel aus Platin, welcher an seiner Oberfläche eine Goldbeschichtung aufweist. Solche Manteldrähte werden vorzugsweise als Anschlussleitungen bzw.

Zuleitungsdrähte für schichtförmige Messwiderstände, insbesondere für Messwiderstände zur Temperaturmessung, verwendet.

Die GB 400,808 beschreibt ein Verfahren zur Herstellung von Drähten mit Edelmetallmänteln für Dentalanwendungen. Dabei sind in der Beschreibung auch Manteldrähte für andere, nicht näher spezifizierte Anwendungen offenbart, die einen Kern aus einer Nickel-Legierung und einen Mantel aus Platin aufweisen.
Als Kernmaterial für die dentalen Anwendungen sind folgende Nickel-Legierungen genannt:
- Nickel-Legierung mit 1% Mangan und ca. 0,5% Silizium,
- Nickel-Legierung mit 55% Nickel und 45% Eisen sowie
- Nickel-Legierung mit Mangan, Aluminium, Eisen und Silizium im Bereich bis zu 5%. Dieses Kernmaterial ist mit einer Zwischenschicht aus Platin, Rhodium, Palladium oder einer Edelmetall-Legierung wie Silber-Palladium oder Gold-Palladium beschichtet, die wiederum mit einer Deckschicht aus Gold belegt ist.

Aufgabe der vorliegenden Erfindung ist es, Platin-Manteldrähte zu schaffen, die auch im Einsatz bei Temperaturen oberhalb von 550°C ihre Stabilität aufrechterhalten.

Die Aufgabe wird erfindungsgemäß dadurch gelöst, dass der Kern aus einer sich an der Kernoberfläche selbst passivierenden Nickel-Basis-Legierung besteht und wobei die Nickel-Basis-Legierung einen Anteil von Chrom im Bereich von 16 bis 22 Gew.-% aufweist.

Die Aufgabe wird erfindungsgemäß weiterhin dadurch gelöst, dass der Kern aus einer sich an der Kernoberfläche selbst passivierenden Nickel-Basis-Legierung besteht und wobei die Nickel-Basis-Legierung neben einem Anteil von Chrom zusätzlich einen Eisenanteil aufweist. Besonders bevorzugt ist es dabei, wenn der Eisenanteil der Nickel-Basis-Legierung im Bereich von 0,5 bis 10 Gew.-%, vorzugsweise bei 8 Gew.-%, liegt.

Die Aufgabe wird erfindungsgemäß weiterhin dadurch gelöst, dass der Kern aus einer sich an der Kernoberfläche selbst passivierenden Nickel-Basis-Legierung besteht und wobei die Nickel-Basis-Legierung zusätzlich einen Aluminiumanteil aufweist.
Besonders bevorzugt ist es dabei, wenn der Aluminiumanteil der Nickel-Basis-Legierung im Bereich von 0,05 bis 5 Gew.-% liegt.

Enthält die Nickel-Basis-Legierung als Legierungselemente Chrom und Eisen oder als Legierungselement Aluminium, so hat es sich bewährt, wenn sie einen Anteil von Chrom im Bereich von 16 bis 22 Gew.-% aufweist.

Insbesondere wird für die erfindungsgemäßen Manteldrähte ein Anteil von Chrom im Bereich von 20 Gew.-% bevorzugt.

Es hat sich bewährt, wenn der äußere Durchmesser des Mantels im Bereich von 0,05 bis 0,4 mm, insbesondere bei 0,2 mm, liegt.
Es ist von Vorteil, wenn der Platin-Anteil (pro Längeneinheit) im Bereich von 10 bis 50 Gew.-% liegt.
Ein solcher Manteldraht weist Zugfestigkeitswerte im Bereich von 400 bis 1200 N/mm² auf, wobei die Streckgrenze im Bereich von 175 bis 250 N/mm² liegt und eine Bruchdehnung von 15 bis 35 % erreicht wird.

Ein wesentlicher Vorteil dieser Manteldrähte ist darin zu sehen, dass die sich an der Kernoberfläche selbst passivierende Nickel-Basis-Legierung sowohl die innere Oxidation des Kems als auch die Bildung einer äußeren Nickeloxidhaut auf dem Platinmantel bei Temperaturen oberhalb 550°C verlangsamt beziehungsweise verhindert. Es wird weitgehend unterbunden, dass Nickel durch den Platinmantel diffundiert, auf der Manteloberfläche oxidiert und die oben beschriebenen Probleme erzeugt.

Ein wesentliches Merkmal der Erfindung besteht darin, dass die Passivierung der Kernoberfläche die Funktion des Platinmantels als einen edelmetallischen, hochtemperaturfesten, fügbaren Schutz, wie z.B. beim Bonden oder Schweißen, lange erhält. Zusätzliche Goldbeschichtungen, die den Preis des Manteldrahtes erhöhen, erübrigen sich damit.

Die Verwendung eines Manteldrahtes mit einem Mantel, der Platin aufweist und der einen Kern aus einer Legierung umhüllt, wobei der Kern aus einer sich an der Kernoberfläche selbst passivierenden Nickel-Basis-Legierung besteht, als Anschlussdraht für elektrische Temperatursensoren ist ideal.
Ein wesentlicher Vorteil der Verwendung solcher Manteldrähte als Anschlussdraht für elektrische Temperatursensoren ist darin zu sehen, dass sich die an der Kernoberfläche selbst passivierende Nickel-Basis-Legierung sowohl die innere Oxidation des Kerns als auch die Bildung einer äußeren Nickeloxidhaut auf dem Platinmantel bei Temperaturen oberhalb 550°C verlangsamt beziehungsweise unterbindet. Es wird weitgehend verhindert, dass Nickel durch den Platinmantel diffundiert, auf der Manteloberfläche oxidiert und die oben beschriebenen Probleme erzeugt.

Besonders hat es sich dabei bewährt, wenn eine Nickel-Basis-Legierung mit einem Anteil von Chrom im Bereich von 16 bis 22 Gew.-%, insbesondere im Bereich von 20 Gew.-%, verwendet wird.

Es ist von Vorteil, wenn eine Nickel-Basis-Legierung verwendet wird, die neben einem Anteil von Chrom zusätzlich einen Eisenanteil aufweist. Dabei hat es sich bewährt, wenn der Eisenanteil der Nickel-Basis-Legierung im Bereich von 0,5 bis 10 Gew.-%, insbesondere im Bereich von 8 Gew.-%, liegt.

Es ist weiterhin von Vorteil, wenn eine Nickel-Basis-Legierung verwendet wird, die zusätzlich einen Aluminiumanteil aufweist. Dabei hat es sich bewährt, wenn der Aluminiumanteil der Nickel-Basis-Legierung im Bereich von 0,05 bis 5 Gew.-% liegt.

Die Verwendung eines Manteldrahtes mit einem äußeren Durchmesser des Mantels im Bereich von 0,05 bis 0,4 mm, insbesondere von 0,2 mm, ist von Vorteil.
Ein Platin-Anteil (pro Längeneinheit) im Bereich von 10 bis 50 Gew.-% hat sich bewährt.

Zur Herstellung eines erfindungsgemäßen Manteldrahtes dient beispielsweise ein Rundstab aus einer Nickel-Basis-Legierung - vorzugsweise mit einem Anteil von Chrom im Bereich von 16-22 Gew.-% -, welcher den späteren Kernwerkstoff bildet. Auf den Rundstab wird ein Rohr aus einem Platin aufweisenden Mantel aufgezogen, in dem die Stabrohranordnung durch einen Hartmetallziehstein auf einen Durchmesser von ca. 6 bis 20 mm, vorzugsweise auf einen Durchmesser von 8 bis 12 mm gezogen wird. Danach wird die Stabrohranordnung in vier bis fünf Zwischenschritten bis zu einem Enddurchmesser von 0,05 mm bis 0,4 mm, bevorzugt 0,20 mm, gezogen, wobei nach jedem Verformungsprozess eine Diffusionsglühung bei einer Temperatur von ca. 1000°C durchgeführt wird. Aus einem solchen Stab kann somit ein mit Mantel versehener Verbunddraht hergestellt werden, welcher als Zuleitung bzw. Anschlussdraht für Messwiderstände geeignet ist.

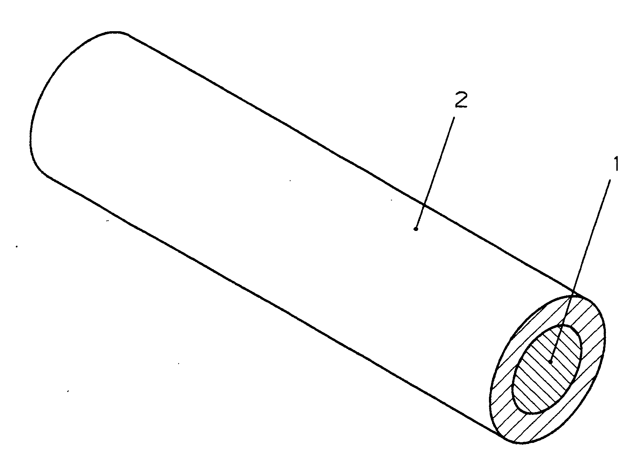

Im folgenden ist der Gegenstand anhand der Figur näher erläutert.

Gemäß der Figur besteht der Kern 1 des Manteldrahtes aus einer sich an der Kernoberfläche selbst passivierenden Nickel-Legierung, vorzugsweise Nickel-Chrom-Eisen - oder Nickel-Chrom-Legierung. Vorteilhafterweise wird eine Nickel-Chrom-Legierung mit prozentualen Gewichtsanteilen von 80:20 % eingesetzt, um bis zu einer Temperatur von 750°C die Diffusion von Nickel-Atomen des Kernwerkstoffes durch den Platinmantel zu verhindern. Somit kann der Anschlussdraht in einem Zeitraum von über 2000 Betriebsstunden bei einer Temperatur von bis zu 750°C in seiner Funktion erhalten bleiben.

Der Kern des Manteldrahtes 1 wird gemäß der Figur von einem Platinmantel 2 umgeben, dessen Dicke im Bereich von 1 µm bis 50 µm liegt, vorzugsweise wird eine Manteldicke von 8 µm eingesetzt.

## Patentansprüche

1. Manteldraht, insbesondere Anschlussdraht für elektrische Temperaturensensoren mit einem Mantel, der Platin aufweist und der einen Kern aus einer Legierung umhüllt, wobei der Kern aus einer sich an der Kernoberfläche selbst passivierenden Nickel-Basis-Legierung besteht und wobei die Nickel-Basis-Legierung einen Anteil von Chrom im Bereich von 16 bis 22 Gew.-% aufweist.

2. Manteldraht, insbesondere Anschlussdraht für elektrische Temperaturensensoren mit einem Mantel, der Platin aufweist und der einen Kern aus einer Legierung umhüllt, wobei der Kern aus einer sich an der Kernoberfläche selbst passivierenden Nickel-Basis-Legierung besteht und wobei die Nickel-Basis-Legierung neben einem Anteil von Chrom zusätzlich einen Eisenanteil aufweist.

3. Manteldraht nach Anspruch 2, **dadurch gekennzeichnet, dass** der Eisenanteil der Nickel-Basis-Legierung im Bereich von 0,5 bis 10 Gew.-% liegt.

4. Manteldraht, insbesondere Anschlussdraht für elektrische Temperaturensensoren mit einem Mantel, der Platin aufweist und der einen Kern aus einer Legierung umhüllt, wobei der Kern aus einer sich an der Kernoberfläche selbst passivierenden Nickel-Basis-Legierung besteht und wobei die Nickel-Basis-Legierung zusätzlich einen Aluminiumanteil aufweist.

5. Manteldraht nach Anspruch 4, **dadurch gekennzeichnet, dass** der Aluminiumanteil der Nickel-Basis-Legierung im Bereich von 0,05 bis 5 Gew.-% liegt.

6. Manteldraht nach einem der Ansprüche 2 bis 5, **dadurch gekennzeichnet, dass** die Nickel-Basis-Legierung einen Anteil von Chrom im Bereich von 16 bis 22 Gew.-% aufweist.

7. Manteldraht nach einem der Ansprüche 1 bis 6, **dadurch gekennzeichnet, dass** die Nickel-Basis-Legierung einen Anteil von Chrom im Bereich von 20 Gew.-% aufweist.

8. Manteldraht nach einem der Ansprüche 1 bis 7, **dadurch gekennzeichnet, dass** der äußere Durchmesser des Mantels im Bereich von 0,05 bis 0,4 mm, liegt.

9. Manteldraht nach Anspruch 8, **dadurch gekennzeichnet, dass** der äußere Durchmesser des Mantels bei 0,2 mm liegt.

10. Manteldraht nach einem der Ansprüche 1 bis 9, **dadurch gekennzeichnet, dass** der Platin-Anteil (pro Längeneinheit) im Bereich von 10 bis 50 Gew.-% liegt.

11. Verwendung eines Manteldrahtes mit einem Mantel, der Platin aufweist und der einen Kern aus einer Legierung umhüllt, wobei der Kern aus einer sich an der Kernoberfläche selbst passivierenden Nickel-Basis-Legierung besteht, als Anschlussdraht für elektrische Temperatursensoren.

12. Verwendung nach Anspruch 11, **dadurch gekennzeichnet, dass** die Nickel-Basis-Legierung einen Anteil von Chrom im Bereich von 16 bis 22 Gew.-% aufweist.

13. Verwendung nach Anspruch 12, **dadurch gekennzeichnet, dass** die Nickel-Basis-Legierung einen Anteil von Chrom im Bereich von 20 Gew.-% aufweist.

14. Verwendung nach den Ansprüchen 11 bis 13, **dadurch gekennzeichnet, dass** die Nickel-Basis-Legierung neben einem Anteil von Chrom zusätzlich einen Eisenanteil aufweist.

15. Verwendung nach Anspruch 14, **dadurch gekennzeichnet, dass** der Eisenanteil der Nickel-Basis-Legierung im Bereich von 0,5 bis 10 Gew.-% liegt.

16. Verwendung nach einem der Ansprüche 11 bis 13, **dadurch gekennzeichnet, dass** die Nickel-Basis-Legierung zusätzlich einen Aluminiumanteil aufweist.

17. Verwendung nach Anspruch 16, **dadurch gekennzeichnet, dass** der Aluminiumanteil der Nickel-Basis-Legierung im Bereich von 0,05 bis 5 Gew.-% liegt.

18. Verwendung nach einem der Ansprüche 11 bis 17, **dadurch gekennzeichnet, dass** der äußere Durchmesser des Mantels im Bereich von 0,05 bis 0,4 mm liegt.

19. Verwendung nach Anspruch 18, **dadurch gekennzeichnet, dass** der äußere Durchmesser des Mantels bei 0,2 mm liegt.

20. Verwendung nach einem der Ansprüche 11 bis 19, **dadurch gekennzeichnet, dass** der Platin-Anteil (pro Längeneinheit) im Bereich von 10 bis 50 Gew.-% liegt.
